(19) Europäisches Patentamt

European Patent Office

Office européen des brevets

(11) Publication number: **0 464 076 B1**

(12) **EUROPEAN PATENT SPECIFICATION**

(45) Date of publication of patent specification: **18.05.94**

(51) Int. Cl.5: **G01R 15/02**, H02H 1/00, G12B 17/02

(21) Application number: **90904843.1**

(22) Date of filing: **23.03.90**

(86) International application number:
**PCT/FI90/00076**

(87) International publication number:
**WO 90/11529 (04.10.90 90/23)**

(54) **APPARATUS AND METHOD FOR MEASURING ELECTRIC CURRENT IN CONDITIONS OF HIGH INTERFERENCE.**

(30) Priority: **23.03.89 FI 891437**
**09.10.89 FI 894792**

(43) Date of publication of application:
**08.01.92 Bulletin 92/02**

(45) Publication of the grant of the patent:
**18.05.94 Bulletin 94/20**

(84) Designated Contracting States:
**CH DE FR IT LI SE**

(56) References cited:
**EP-A- 0 176 634**
**GB-A- 2 062 251**

(73) Proprietor: **ABB STROMBERG KOJEET OY**
**PL 622**
**SF-65101 Vaasa(FI)**

(72) Inventor: **SOLANTI, Petri**
**Orivedenkatu 16 C 61**
**SF-33720 Tampere(FI)**
Inventor: **TENHUNEN, Hannu**
Helakuja 4
**SF-33720 Tampere(FI)**
Inventor: **KIISKINEN, Esko**
**Läntinen Pitkäkatu 7**
**SF-65380 Vaasa(FI)**
Inventor: **SUUTARI, Jukka**
**Säästäjänkatu 13 E 29**
**SF-33840 Tampere(FI)**
Inventor: **SIIKONEN, Martti**
**Nummikatu 19**
**SF-65230 Vaasa(FI)**

(74) Representative: **Orès, Bernard**
**Cabinet ORES**
**6, Avenue de Messine**
**F-75008 Paris (FR)**

## Description

The present invention relates to an apparatus in accordance with the preamble of claim 1 for measuring electric current in conditions of high interference in order to control, e.g., an overload protective device.

The invention also concerns a method for measuring electric current in accordance with the preamble of claim 5.

The invention is particularly aimed at operation in conjunction with a thermal overload relay of a motor. With the help of the invention, the temperature behaviour of the motor is deduced from the current flowing in the current conductors of the motor by means of integration of motor temperature. In overload situations, the thermal overload relay disconnects the motor from the supply according to a standardized operating curve.

EP-A-0 176 634 describes a device for monitoring the consumption of electrical power comprising a Hall effect sensing unit applied externally to a cable.

EP-A-0 176 634 does not describe the use of a comb-shaped core.

Current measurement is implemented by means of Hall-effect semiconductor sensors well-known in the art that are placed in accordance with the invention. The sensors measure the magnetic flux density induced by the current flowing in the conductor. In this means a voltage information is obtained capable of being converted into a digital form.

On the basis of the digital information, the integrating counter is fed with a frequency which steers the counting, thus approximating the temperature increase or decrease in the motor. When the counter reaches a set critical level, it issues the trip relay a signal to disconnect the motor from the supply.

Overview of conventional implementations

Thermal overload relays based on current measurement are available in two categories: inexpensive electromechanical thermal overload relays based on bimetal strips and microprocessor-based overload relays with appreciably higher cost (about 10 times as much).

The bimetal thermal relay having a basic construction with a history of several decades approximates the temperature increase and decrease in the motor through heating a bimetal strip. The strip is surrounded by a resistor wire winding through which the motor current passes and thereby heats the strip with a power level proportional to the square of the current. As soon as the strip temperature reaches the trip temperature, i.e., the strip bends sufficiently to trigger the trip mechanism, the contacts controlled by the mechanism are opened. The strips regain their original straightness as they cool, and a return mechanism recloses the contacts when the strips have cooled to near ambient temperature.

A microprocessor-based overload trip relay measures the motor current by means of current transformers and estimates the motor temperature by a computation program. In addition, the processor makes it possible to implement some auxiliary functions such as the monitoring of supply neutral lead current and earth faults as well as undercurrent situations.

Major problems of the bimetal thermal relay are its sensitivity to ambient temperature variations, the relatively narrow current range available with a single device, and the low thermal inertia of the bimetal strip in relation to the mass of the motor, which particularly affects the possibilities of approximating the cooling behaviour of the motor.

Implementations based on the use of a microprocessor allow for overcoming all drawbacks of the bimetal thermal relay, however, these devices are large and costly, and moreover, the current measurement method used in them results in a cumbersome assembly and high production cost.

Scope of the invention

The aim of this invention is to overcome the disadvantages of prior-art methods described above and to achieve a novel type of apparatus and a method for measuring electric current in conditions of high interference, particularly for use in a thermal overload relay application.

The invention is based on having the measurement apparatus comprise Hall sensors placed close to the current conductors and magnetic flux concentrators placed about the current conductors.

More specifically, the apparatus in accordance with the invention is characterized by what is stated in the characterizing part of claim 1.

Furthermore, the method in accordance with the invention is characterized by what is stated in the characterizing part of claim 5.

Current measurement is implemented by means of the Hall sensors placed close to the current conductors. By selection of appropriately sensitive Hall sensors, a current range wider than that available in bimetal or microprocessor-based thermal overload relays is achieved.

In order to be able to approximate the motor temperature with a due elimination of the effect of ambient temperature, the thermal energy indicator must be temperature-independent. This requirement is solved by the use of a counter construction. The analog information obtained from the Hall sensors in converted into a digital form whose magnitude in combination with the nominal value of current determines whether the counter is fed with a decrementing or incrementing frequency, depending on where the current signal falls within measurement range. The integrating counter is an up/down counter, whose counting frequency and direction is directly obtained from the binary form of the current output signal of the analog section. The counter construction provides for the elimination of possible heat oscillation occurring, for instance, in bimetal thermal relays due to the appreciably lower heated thermal mass of the bimetal relay in comparison with that of the motor, which leads to a correspondingly faster cooling. In the counter construction, a motor-specific cooling rate is selectable. This principle allows for the construction of an electronic thermal overload relay with a cost only marginally higher than that of a bimetal thermal overload relay.

Significant benefits of the invention

The apparatus is capable of accurately estimating the heating curve of a motor and thus prevents heat oscillations which could damage the motor.

The digital logic circuitry offers auxiliary functions which are impossible to implement with a bimetal thermal overload relay. For instance, the apparatus can be connected to a remote control, thereby allowing the apparatus to alert a control center for an overload situation and cause of tripping. Further, the apparatus is remote-controllable from the control center. Moreover, it can be provided with the monitoring of the supply neutral lead current for the detection of a phase leg fault or load unbalance.

The digital apparatus provides better estimation of the actual cooling curve of the motor than a bimetal relay by virtue of being unconstrained by a heated thermal mass lower than that of the motor, thus allowing for an individual adjustment of the cooling curve for each motor.

The construction of the apparatus is insensitive to ambient temperature. The use of Hall sensors offers a wider range of operating current in the relay modules; for instance, the range 2...125 A can be covered with three modules, while the needed number of different sizes of bimetal thermal overload relays would be about 20.

The invention is explained in detail with the help of exemplifying embodiments illustrated in the attached drawings.

Figure 1 shows the connection of an overload relay in accordance with the invention at a block diagram level.

Figure 2 shows in a graph a standardized time-current operating curve.

Figure 3 shows the operating panel of an overload relay in accordance with the invention.

Figure 4 shows an overload relay in accordance with the invention in a detailed block diagram.

Figure 5 shows a Hall-effect sensor in a perspective view.

Figure 6 shows the analog section of an overload relay in accordance with the invention in a detailed block diagram.

Figure 7 shows the digital section of an overload relay in accordance with the invention in a detailed block diagram.

Figure 8 shows the placement of Hall sensors in an overload relay in accordance with the invention seen from the direction of the current conductors.

Figure 9 shows in a side view a single Hall sensor of the type illustrated in Fig. 8.

Figure 10 shows diagrammatically the phase sequencer of the apparatus in accordance with the invention.

Figure 11 shows diagrammatically the voltage level sequencer of the apparatus in accordance with the invention.

Figure 12 shows diagrammatically the overload signal delay circuitry of the apparatus in accordance with the invention.

Figure 13 shows diagrammatically the voltage level latch circuitry of the apparatus in accordance with the invention.

Figure 14 shows diagrammatically the frequency generator of the apparatus in accordance with the invention.

Figure 15 shows diagrammatically the frequency multiplexer of the apparatus in accordance with the invention.

Figure 16 shows diagrammatically the up/down counter of the apparatus in accordance with the invention.

Figure 17 shows diagrammatically the comparator block of the apparatus in accordance with the invention.

Figure 18 shows diagrammatically the stalled start detection logic of the apparatus in accordance with the invention.

Figure 19 shows diagrammatically the underload detection logic of the apparatus in accordance with the invention.

Figure 20 shows diagrammatically the test sequencer of the apparatus in accordance with the invention.

Figure 21 shows diagrammatically the output buffer register of the apparatus in accordance with the invention.

## GENERAL DESCRIPTION OF THE ELEMENTS IN THE INVENTION

### Main functions

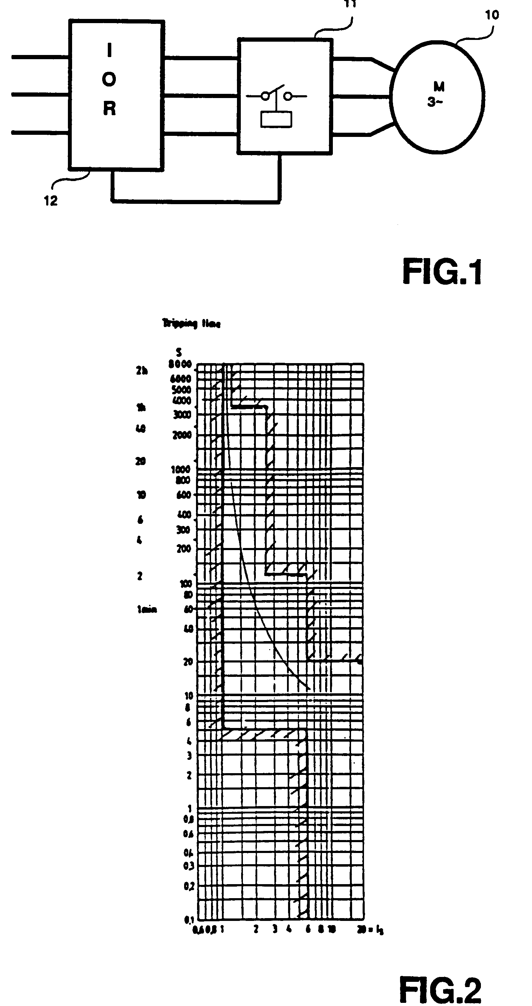

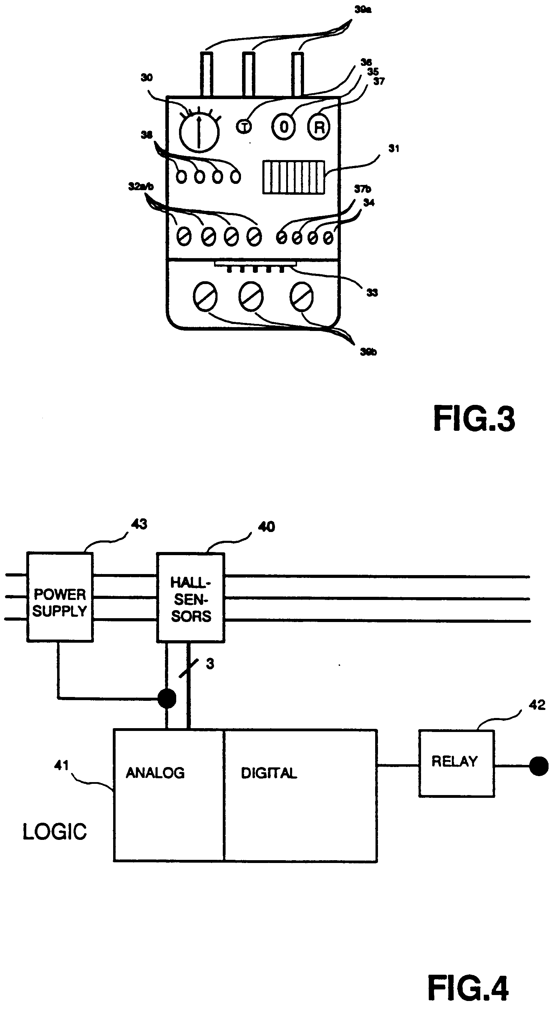

As illustrated in Fig. 1, the Intelligent Electronic Overload Relay 12 is designed for use as an overload protection of three-phase motors 10 over the current range 2...125 A. The overload relay apparatus is placed between the supply and the motor 10 for the purpose of actuating the tripping of the motor in case the motor becomes overheated by overload or any other malfunction. The operating current range is divided into subranges: 2...24 A, 20...80 A and 63...125 A. Using predetermined computational functions, the overload relay apparatus processes the voltage signal provided by Hall-effect sensors. The Hall sensor 12, signal-conditioning circuit 12 and relay 11 are supplied from an auxiliary voltage of 110...220 V, which is also separately routed to the thermal overload relay. According to Fig. 3, the operating mode is user-settable by DIP switches 31, while a potentiometer 30 with a calibrated scale is used for setting the current range. Other interfacing or functional elements related to the operation of the apparatus are two output terminals 32, one flat-cable connector 33, one pair of input terminal 34 for the auxiliary voltages, one pair of input terminals 37b, 35 for the remote-controlled reset, a Test pushbutton 36 and a Reset pushbutton 37a, as well as four LED lamps 38 for indication of the operating condition and cause of tripping, optionally complemented with a facility for instrument bus connection.

Major causes of interference imposed by the environment deserve extremely careful attention. Therefore, the use of sensitive Hall sensors in the overload relay apparatus necessitate the use of a Faraday shield construction as a protection against external electromagnetic fields, while the desired field is concentrated by means of a ferromagnetic core at the most sensitive spot of the Hall sensor. A reference Hall sensor is further added in order to attain the compensation of any possible remaining interference signal from corrupting the measurement. Aiming at utmost reduced total cost, the construction of the apparatus has been designed for maximum simplicity.

### PRINCIPAL CHARACTERISTICS

#### Function of the overload relay

The actuator element of an overload protective device is a relay which controls a contactor. The contactor performs the tripping of the motor from the supply, thus preventing damage to the motor. The relay of the apparatus is controlled by a customer-specific integrated circuit (ASIC). A Hall sensor provides the necessary voltage input signal for the logic circuitry. The sensor signal is linearly proportional to the current flowing in the supply conductor to the motor.

#### Time-current operating function

The time-current operating function (Fig. 2) of the overload relay is compliant with standardized curves. Since a separate temperature sensor is not available, the motor temperature is derived from a computational function of the overcurrent exceeding the nominal current. The overload relay apparatus estimates the heat generated by the overcurrent through integration into a counter at seven different current levels, namely the multiples of 0.7, 0.95, 1.05, 1.19, 1.25, 1.45, 1.7, 2.0, 2.5, 2.8, 3.4, 4.0 and 5.0 of the nominal current $I_n$. The overload relay decides on the tripping along the following rules: At the current level of

4

EP 0 464 076 B1

$1.05 \cdot I_n$, no tripping may take place within two hours; if the current is increased hereafter to $1.2 \cdot I_n$, tripping must occur in about half hour. Equally, the increase of the current from the heated condition to $1.5 \cdot I_n$ must result in tripping in less than two minutes. Immediate stepping of the load current to $5 \cdot I_n$ in a cold start must result in tripping in 2, 8, 16 or 26 seconds, selectably. This characteristic is provided to allow for the use of motors in machinery imposing a long start-up load. The logic circuitry of the overload relay apparatus processes the current signal of one phase leg at a time. The current signal of the phase leg is converted into RMS voltage signal levels which are compared against a potentiometer-settable reference level.

When the start-up time is set for the shortest possible which is two seconds, the logic allows, in addition to the actual starting, two additional attempts to a renewed starting within two minutes in such cases in which the current level exceeds the $5 \cdot I_n$ level immediately at start-up and stays at the high level up to tripping. If the motor current exceeds the $5 \cdot I_n$ level even during the second start-up, again remaining at the high level up to tripping, the apparatus forces a period of 30 min for the cooling of the motor prior to the next repeated attempt to start-up. If the eight-second start-up duration is selected, the logic allows only one attempt to a repeated start-up.

The overload relay apparatus is also capable of performing phase leg fault monitoring by way of comparing the phase leg currents mutually. Opening of the motor circuit by the overload relay is disabled at current levels less than $0.2 \cdot I_n$. When the highest leg current of the three phase legs exceeds the limit $0.2 \cdot I_n$, tripping is enabled with a one-second time delay provided that a difference greater than 90 % exists between any two phase leg currents.

A further optional function is the underload indication. The desired detection level is selected by DIP switches from preset 20, 50, 70 and 95 % levels which are generated from the nominal current. The available undercurrent ranges are: <0.2, 0.2...0.5, 0.2...0.7 and $0.2...0.95 \cdot I_n$. At the detection of underload, the overload relay apparatus issues an alarm to the control center at a one-second time delay.

The optional functions further include the indication of ground-fault current. For this purpose, the current signals from the phase leg current sensors are summed and, for normal operation, the sum must be 0; if the sum differs by more than 15 % from the set reference level, an alarm is issued to the control center. The alarm function, however, is inhibited for the duration of the start-up sequence in order to provide for the stabilization of the analog section functions and attainment of representative signal values for summation.

Due to delicate construction of the potentiometers used for setting the current ranges, their function needs continual monitoring. If the circuitry detects a wiper discontinuity lasting longer than 0.5 s, the malfunction situation is avoided by configuring such preamplifiers that are connected to a potentiometer into voltage followers.

The user is alerted on the functional and tripping status by way of four LED lamps mounted at the front panel of over-current trip relay. Overload situations are indicated by a blinking "Overload/Trip" LED lamp. At the overheating of the motor resulting in a tripping, the "Overload/Trip" LED lamp stays lit. If the tripping is caused by a tripped fuse, also activating the phase leg fault monitoring, the "Fuse error" LED lamp is lit. The "Stall" LED lamp is lit if the motor current during start-up immediately exceeds the $5 \cdot I_n$ level remaining at this high level up to tripping, thus indicating a stalled-rotor situation. Tripping caused by a ground fault is indicated by the "Gnderror" LED lamp. The front panel LED lamps always indicate the last alarm status only. Blanking of the indicator lamp panel is possible by pressing the "Reset" pushbutton.

Pressing the "Test" pushbutton activates the self-test of the apparatus, which lasts two seconds. During the test, the circuitry performs tripping in two seconds, followed by a complete resetting of entire circuitry. The "Test" pushbutton is operable only when the up/down counter is in the "down" state and the counter indicates a cold motor.

Pushing the "Reset" pushbutton clears the "Output buffer" register from the "tripped" status and enables a renewed start-up. The clear function is inhibited for a set time from the tripping in order to prevent heat oscillations in the motor.

In the automatic operating mode, the overcurrent trip relay is reset according to the following table:

| Trip time delay | Inhibit duration |
| --- | --- |
| 2 s | 2 min/30 min |
| 8 s | 2 min/30 min |
| 16 s | 1 h |
| 26 s | 2 h |

The "0" trip button can be used for stopping the motor even in normal operating conditions.

5

The panel of the overload relay is further provided with adjustment controls, which are implemented using, for instance, DIP switches. These controls are used for setting the time delay of the $5 \cdot I_n$ trip current level. Furthermore, the switches are used for setting a manual or automatic reset mode after tripping. The underload function and set levels of current are switch-selectable.

The panel has an output connector for the control circuit of the contactor coil and the alarm circuit used for indicating a tripped status of the relay.

An input connector is provided for implementing the remote control of functions corresponding to the operation of the "Reset" pushbutton.

To avoid the need for a separate current meter, an analog current signal proportional to the nominal current is routed to the output card of the process control system.

A 10-pin flat-cable connector is further provided having a pin configuration in which a single signal line indicates the tripping status, four lines are available for latched level signals and dedicated lines are available for alarms on the ground fault, underload and self-test statuses. Additionally, the contactor receives a prewarning signal on an impending tripping as soon as the up/down counter has integrated up to 90 % of total allowed heat load of the motor. All digital output stages are of the open-collector type.

CONNECTIONS AND EXTERNAL STRUCTURES

Controls

According to Fig. 3, the user interface of the overload relay is provided by a potentiometer 30 which is adjustable for setting the scale of nominal current to correspond to the desired function of the relay. The aggregate number of the DIP switches 31 is eight (8). One connector is provided for remote-controlled resetting.

Connections

According to Fig. 3, the overload relay receives the supply conductors of phase legs at screw terminals 39a and the same legs extend through the relay exiting at terminals 39b. In thermal relay modules designed for the 2...25 A current range, the output phase leg terminals are metal bars 39a directly compatible with the screw terminals of the contactor, while modules of the higher current ranges are provided with screw terminals. For connection of the contactor coil circuit the relay has a pair of screw terminals 32a, while the alarm signal output is available at a pair of screw terminals 32b (intended for indication of tripped status), which provide a functionally complementary (inverted) signal. Further, terminals 34 are provided for the connection of the auxiliary voltage. The 10-pin flat-cable connector 33 provides the status signals for an intelligent contactor to be further routed onto a signal bus. A remote-controlled resetting signal is served by a further pair of terminals 37b. The analog signal to a process computer is available via a pin of the flat-cable connector. Such a facility allows for replacing a costly current meter, however, at a reduced accuracy.

Indicators

Violation of nominal current level is indicated by the blinking of the "Overload/Trip" LED lamp indicator mounted at the indicator lamp panel 38 of Fig. 3, while a continuously lit LED lamp indicates trip status. The "Stall" LED lamp indicates tripping by stall conditions, viz., the current has immediately reached the $5 \cdot I_n$ level at start-up remaining at the high level up to tripping. A phase leg fault is indicated by the "Fuse error" LED lamp, which is immediately lit for a difference greater than 90 % in the currents of any two phase legs. The "Gnderror" LED lamp is lit when the sum of phase leg current signals differ by greater than 15 % from the set value. If the self-diagnostics of the relay detects a functional fault, the LED lamps start blinking with those LED staying continuously lit that indicate a tripping or other fault. Depending on the use, the LED lamps can installed at the front cover of the relay enclosure. In this case the LED lamps can either be wired to the cover, or alternatively, the light from the LED lamps can be routed to the cover by means of light guides assembled in front of the LED lamps.

External components and structures

The only external component required by the thermal overload relay is a contactor. Incoming signal to the relay is an external "Reset" signal which performs a similar function as the Reset pushbutton. Outgoing signals from the relay are the control voltage of the contactor coil, the alarm output and the flat-cable connector signals, possibly complemented with an optional bus interface using a serial communications protocol.

The input signal "Reset" has a similar function as the Reset pushbutton, viz., the signal achieves the clearing function of the output buffer register, provided that the signal is not issued prior to the expiration of the inhibit times from the occurrence of tripping.

The outputs for the contactor coil control and alarm provide latched signals. The contactor coil control output is normally-closed circuit (N/C relay contact), while the alarm output is a normally-open circuit (N/C relay contact). In normal operation, these contacts are forced in opposite positions, whereby loss of supply voltage to the electronics results in the issuance of an alarm, yet not opening the coil circuit.

Use of the relay

In normal use the location of the overload relay is free because of the independent supply of 110...220 V to the auxiliary voltage terminals of the relay. A possible configuration is to connect the phase conductors directly to the supply input terminals, while the outgoing phase conductors are connected directly to the supply terminals of the contactor. The coil control voltage terminals are connected to the coil circuit of the contactor and the alarm circuit conductors are attached to the alarm output terminals of the relay.

At each power-up of the main circuit, the relay performs a self-test sequence and after the test, clears the counters. If the remaining energy in the digital section supply is sufficient after a supply voltage loss, the counters are not cleared.

The adjustment of the nominal current scale is performed during assembly in a test bench. The nominal current can be set to a desired value with the help of the scale, or alternatively, in the actual operating environment of the running motor, whereby the nominal current adjustment can be matched with the running current.

Functional description

According to Fig. 4, the functional units of the overload relay are:
- current measurement section 40
- logic circuitry section 41
- control section 42
- power supply 43.

Current in each phase leg conductor is measured by way of the magnetic field induced by the current about the conductor. The magnetic flux density, or magnetic induction, is measured with the help of a Hall-effect sensor, whose output is taken as a voltage linearly proportional to the current into the ASIC logic circuitry for further processing of the information. The logic circuitry then provides the control signal for the relay as when to trip the coil current of the contactor.

Current measurement section

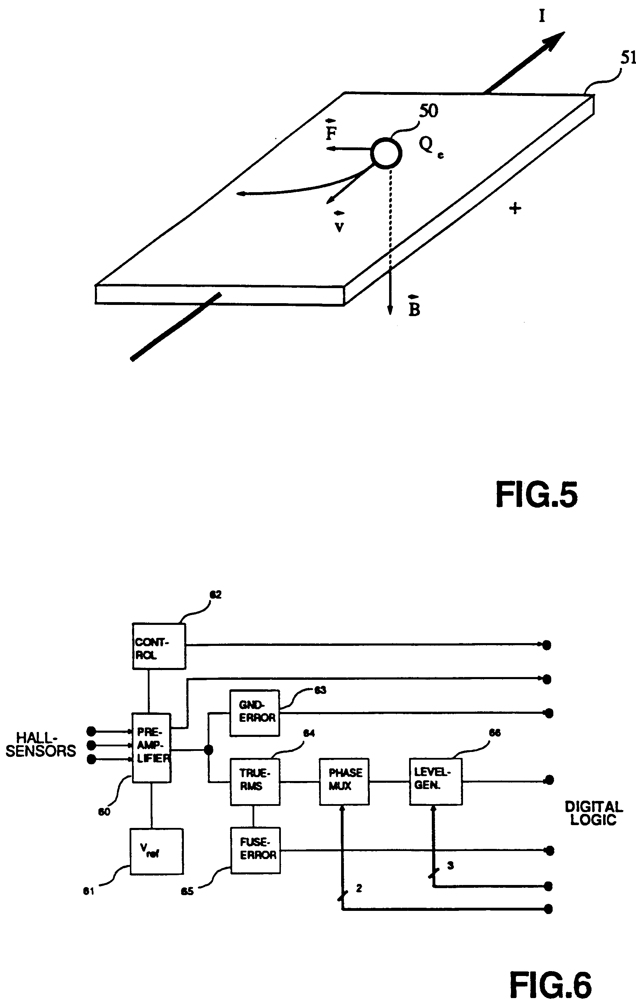

The sensors of the current measurement section are based on the Hall effect, which develops a voltage to the sensor output by way of the perpendicular deviation of electrons 50 by an external magnetic field from their propagation direction as they pass over the active semiconductor area 51 (Fig. 5).

Current measurement is performed using by placing beside the measured conductor (at about 1 mm distance) a Hall sensor, which delivers an analog output voltage directly proportional to the imposed magnetic flux density. The flux density can be increased by the use of a ferromagnetic core, which offers a reduction of interference by the environment.

At 1 mm distance the nominal current in the range 2...125 A induces a free-air magnetic flux density 0.4...25.0 mT, which can further be increased by the use of ferromagnetic core. Greatest difficulties in measurement are caused by the ability to detect small changes in motor current. For instance, a 2 A motor running at 20 % undercurrent level induces a 0.08 mT flux density at the sensor. Therefore, the system must have sufficient resolution to be able to detect changes in the order of some tens of microteslas in the flux density. By contrast, at the $5 \cdot 125$ A = 625 A current level the flux density to be measured is 125 mT, which imposes great demands on the dynamic range of the measurement system.

In practice, the Hall sensors used for said measurement range exhibit a sensitivity of approx. 25 mV/mT.

Because of the extremely high temperature coefficient of the Hall sensors in DC use, the anticipation and compensation of errors is extremely important in order to be able to detect without error the different

7

EP 0 464 076 B1

limit values in different temperatures. Sensor manufacturers provide integral temperature compensation in their products. The invention measures AC signals, thereby rendering the signal insensitive to temperature effects as has been verified by measurements.

When aiming at a higher measurement accuracy, the current path can be modified appropriately in order to achieve a higher magnetic flux at the sensors. For minimum error, the layout of current paths and placement of Hall sensors must also take into account the stray fields caused by the adjacent phase leg conductors. A fourth Hall sensor is added for the detection of interfering fields entering from the environment.

Logic circuitry section

The logic circuitry is divided by the method of signal processing in analog and digital sections. The analog section processes the information received from the sensors into the different voltage level which the digital section uses as control information.

Analog section

Analog section construction

The purpose of the analog section is to process by an analog-to-digital conversion the incoming signal incorporating disturbance components into digital form appropriate for the logic circuitry. Additionally, the analog section performs monitoring for a phase leg fault, ground fault and supply voltage level (Fig. 6).

After DC filtering of the incoming signal, the analog section performs an RMS value conversion of the voltage signal. Then, the DC signal is divided into voltage levels which correspond to the different set levels of the nominal current. Comparison of the voltage levels against a voltage reference gives the current value in digital form.

The functional blocks of the analog section are:
- Isolation amplifier 60
- Adjustable amplifier 60
- Voltage reference 61
- Potentiometer monitoring block 62
- Ground fault monitoring block 63
- True-RMS converter 64
- Phase leg fault detector 65
- Level detection block (level generator) 66
- Auxiliary supply voltage monitoring block 62
- Binary information block 60 of potentiometer-selectable nominal current range.

Digital section

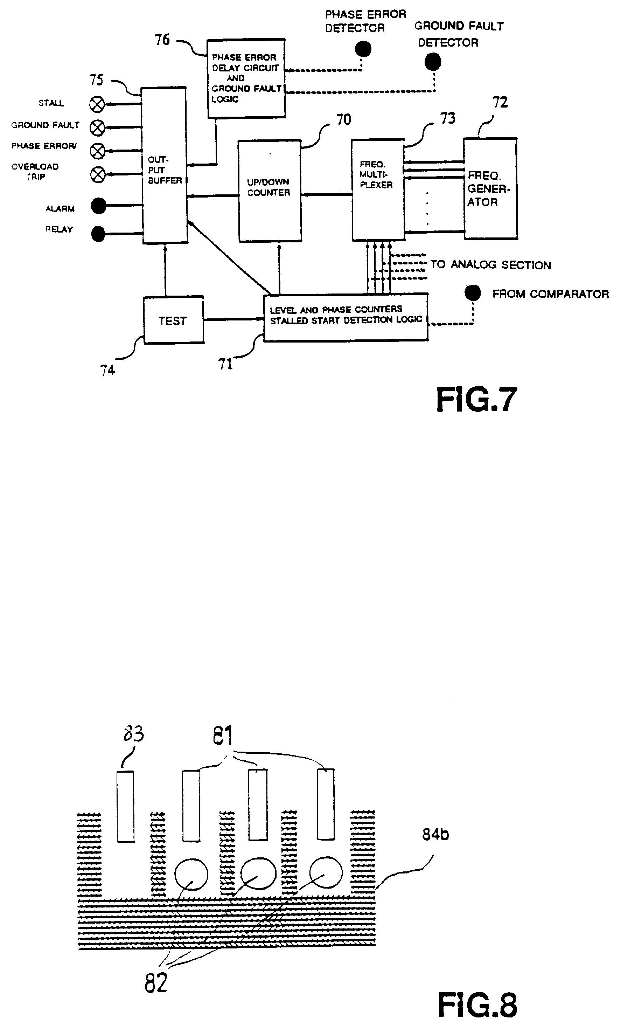

Control information received by the digital section (Fig. 7) dictates the frequency of the clock signal to be fed to an up/down counter 70. At the detection of an overcurrent situation, the counter is driven into the incrementing direction. In all other cases the counter is set to count in the decrementing direction. After once entering the overcurrent state, the counter is inhibited to switch back to the decrementing mode until all phase leg current are detected to be below the nominal current $I_n$. According to similar rules, when the counter state is above the level $0.7 \cdot I_n$ or $0.95 \cdot I_n$, respectively, the counters are decremented until the heat load level integrated into the counters reaches the actual running current level of the motor. At the reach of the counter's capacity, the counter triggers the tripping and issues an "Overload" pulse, thereby controlling the relay into the tripped state. Simultaneously, the "Overload/Trip" LED lamp is lit in order to indicate the tripped state to the user.

An overcurrent situation is indicated by the blinking of the "Overload/Trip" at a preset frequency.

The basic clock frequency (32 kHz) is used for the timing of phase leg and level selection lines 71 so that the level selection scans through all levels before the next phase leg is selected. After scanning all three phase legs, comparison with the reference leg is performed.

The clock pulse signal is further processed in a frequency generator 72 to obtain the frequencies from which a frequency selection block 73 picks up the necessary frequency to be fed to the counter in order to achieve correct lengths of time for each overcurrent level prior to the tripping.

8

The testing of the generation of analog levels and the function of the digital control logic takes place in a testing block 74 during the monitoring of the fourth phase by way of applying an appropriate voltage to the input of the analog section. Next, the voltage levels generated from the voltage signal are monitored normally and the logic circuitry performs monitoring of level violation at a set level. If the level violation is detected at an incorrect point, an alarm is issued and all LED lamps are lit to indicate a functional fault detected by the self-diagnostics.

The test circuitry of the counters 70 and the output buffer register 75 incorporates a watchdog counter measuring the time for 2 s. During this time, the entire test cycle is performed and finally the entire circuitry is reset. The test function initiated by the "Test" button is enabled only when the counter state corresponds to a cool motor and the counter's counting mode is set for decrementing. Then, the pressing of the "Test" button sets the counter in the incrementing mode and feeds the counter with a frequency set to trip the relay in two seconds. Finally, the entire circuitry is reset by a pulse to return to the initial state.

When desired, the automatic reset function can be disabled by setting the "Auto/Man" switch to position "Man". In the manual mode, the relay can be closed by pressing the "Reset" pushbutton. In the automatic mode, the relay is reset automatically after the test times described above.

A phase leg fault always requires manual resetting of the relay.

The control logic is designed not to deactivate the coil circuit of the contactor at an auxiliary voltage fault, but instead, to activate the alarm circuit thus informing of a functional fault. At loss of the supply voltage, the counter of the logic circuitry is set into a low-power mode with a simultaneous inhibit of other functions, whereby the state of the counters can be maintained with the help of stored energy for a maximum time during a power outage. This mode can be safely extended up to about 10 minutes. The analog section incorporates a monitoring function of the supply voltage to the digital circuitry. When the supply voltage falls below 4.0 V, the analog section cuts off supply voltages from the digital section. This approach avoids the generation of any undefined and undetermined state of the counters due to an insufficient supply voltage level.

In accordance with Fig. 7, the blocks of the digital logic section are:

- Level/phase sequencing counter 71
- Up/down counter 70
- Comparator block 70
- Frequency generator 72
- Frequency multiplexer 73
- Stalled start detection logic 71
- Output buffer rgister 75
- Time-delay circuit of phase leg fault detection 76.

Control logic section

In accordance with Fig. 4, the control element 42 of the apparatus is a relay, which further controls the coil circuit of the contactor. The relay makes it possible to interface the control signals from a low-level logic, for instance, the CMOS family, to the high-voltage/high-current environment of the motor. The choice of a relay for interfacing is dictated by the need to attain galvanic isolation between the circuits of the contactor and the overload relay.

Power supply block

The overload relay is fed from a power supply 43 having a Zener diode for prestabilization and a surface-mounted IC voltage regulator for output voltage regulation. Due to the small current consumption of less than 1 mA by the low-level logic circuitry, 3 times 13 mA by the sensors and 450 mW by the relay, the total power consumption remains at as low as about 900 mW. Consequently, their is no problem in providing sufficient power to the components selected for the apparatus.

Run-time self-diagnostics

The overload relay has built-in self-test sequencing both for the analog and the digital sections.

The self-diagnostics of the analog section is programmed to perform a test per each sequence of each phase leg current measurements, viz., when the three physical phase legs are measured, the fourth phase is treated as the check of voltage levels generated by a selected phase sensor output voltage. A violation of a preset test voltage level must occur; otherwise the RMS converter block, the resistive voltage divider

9

network or the amplifier block is faulty. This approach offers a testing facility for the blocks common to all phase leg measurement circuits.

The testing of the digital section is performed at each power-up of the auxiliary supply voltage. The sequenced self-diagnostics tests the counters and the output buffer register by clocking them at maximum frequency. The up/down counter is driven full at maximum frequency, whereby any error in counting indicates a fault in the first stages of the frequency generator. The coil circuit of the contactor is tripped when the counter is full. Simultaneously as the up/down counter is being counted full, the enable signal of a flip-flop is delayed with a low-frequency clock signal to allow the up/down counter to reach maximum count. If the enable signal becomes active prior to the tripping signal, an error signal for malfunction is issued. This approach allows for the testing of the entire configuration of the frequency generator circuitry. The resetting of the output buffer and up/down counter is performed at a five-second delay from the tripping, and the apparatus resumes the normal operating mode. Initialization of the self-diagnostic test is enabled only when the up/down counter is set for the decrementing mode and the counter contents are clear from any integrated heat load to the motor.

ELECTRICAL CHARACTERISTICS

Absolute maximum values

| Description | Rating |
|---|---|
| Operating voltage | 110...480 V |
| Current waveform | Sinewave and inverter use |
| Power consumption | Approx. 900 mW (estimated) |
| Operating temperature | -20...+85 °C |
| Storage temperature | -55...125 °C |

DC characteristics

| Description | Rating |
|---|---|
| Output control specifications: | |
| N/C contact: | |
| Switch-on pwr. rating | 30 W/250 VDC (duration ≈ 4.0 ms) |
| Switch-off pwr. rating | 500 VA (W), $I_{RMS}$ ≈ 5 A |
| Power consumption | Approx. 900 mW (estimated) |
| N/O contact: | |
| Switch-on pwr. rating | 30 W/250 VDC (duration ≈ 40 ms) |
| Switch-off pwr. rating | 1000 VA (W), $I_{RMS}$ ≈ 5 A |
| Power consumption | Approx. 900 mW (estimated) |
| Remote reset | N/A |
| Flat-cable conn. O/P | Open-collector |

11

## AC characteristics

| Description | Rating |
| --- | --- |

**Output control specifications:**

**N/C contact:**

| | |
| --- | --- |
| Switch-on pwr. rating | Approx. 100 VA/250 VAC, $\cos\varphi \approx 0.6$ |
| Switch-off pwr. rating | 500 VA (W), $I_{RMS} \approx 5$ A |
| Power consumption | Approx. 900 mW (estimated) |

**N/O contact:**

| | |
| --- | --- |
| Switch-on pwr. rating | Approx. 100 VA/250 VAC, $\cos\varphi \approx 0.3$ |
| Switch-off pwr. rating | 1000 VA (W), $I_{RMS} \approx 5$ A |
| Power consumption | Approx. 900 mW (estimated) |

Data transfer characteristics

The interface line pins of the flat-cable connector provide tripping information (1 line), latched voltage level signals (4 lines), alarm information on a ground fault (1 line), underload (1 line), self-diagnostics (1 line), impending tripping (1 line) and the analog-form current signal (1 line).

TECHNICAL DESCRIPTION

Current measurement section

Functional description of the current measurement section

The current measurement section measures the motor current over a range of 2...125 A with the help of Hall-effect sensors (Fig. 5). The entire range can be covered by two different sensors.

In accordance with Fig. 8, the sensors 81 are placed beside the conductors 82 in order to utilize the Hall sensor's capability to deliver a voltage signal directly proportional to the imposed magnetic flux density invoked by the current in the conductor. The relationship between the current and magnetic flux density is given:

$$B = 4\pi \cdot 10^{-7} \frac{I}{2\pi r} = I \cdot \frac{2 \cdot 10^{-7}}{r}$$

The magnetic flux density is increased by way of a comb-shaped structure 84b having a function similar to that of permanently fixed metal strips, either structure being placed about the conductor 82 and the sensor 81. By the same token, the field pattern is significantly concentrated, thus eliminating interference from the environment. The entire measurement section is furthermore enclosed in a Faraday shield 85 in order to eliminate the effect of external stray fields. To achieve further improvement in operational reliability, a fourth sensor 83 is placed clear of any current conductor to indicate the external stray fields.

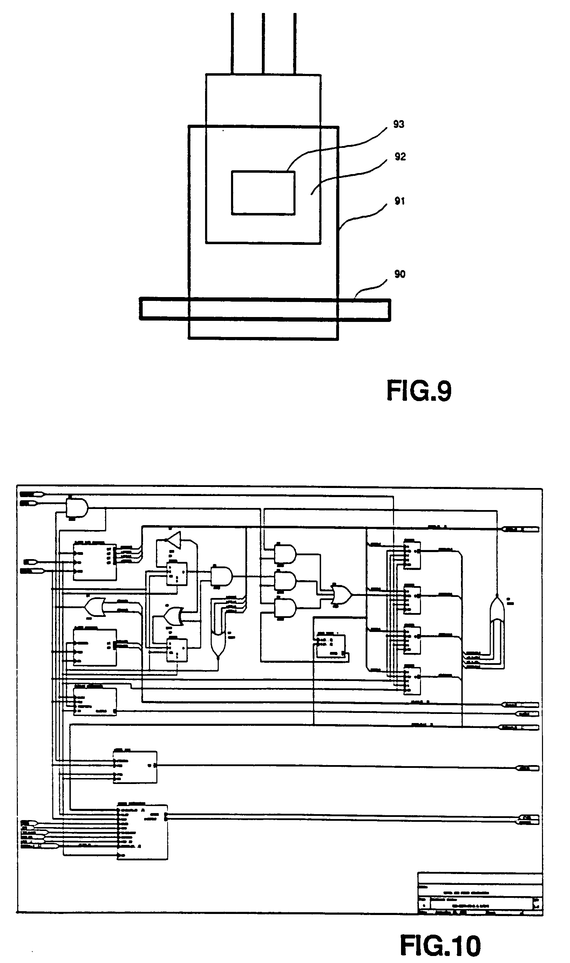

Illustrated in Fig. 9 in a side view one of the Hall sensors shown in Fig. 8. The Hall sensor 92 has an active center area 93 sensitive to the magnetic field, onto which the magnetic field invoked by the current passing in the conductor 90 is concentrated with the help of the ferromagnetic structure 91.

Based on the measurement of AC fields, this application avoids the inherent sensitivity problems of Hall sensors to temperature variations associated with the measurement of DC fields.

Analog section

Functional description of the analog section

The analog section (Fig. 6) performs the conversion of voltage information from the Hall sensors into a true root-mean-square value (True-RMS). The signals are scaled in a resistive voltage divider in order to obtain the signal levels used in the comparison to detect the current level in the conductor. The divided voltage levels are sequentially applied to a comparator, which converts the signals into digital information proportional to the current. The processing of the voltage level signals is performed sequentially for each phase leg. The phase leg (2-bit) and voltage level selection (4-bit) signals are received from the digital logic circuitry.

The phase leg signals are also compared with each other, with a difference of 90 % still being acceptable. This procedure can detect a tripped fuse in the motor circuit.

The analog section gives the digital logic section a 2-bit information on the position of the current range selection potentiometer that is used for the control of the frequency selection multiplexer.

A further function performed by the analog section is the monitoring of ground fault current. If the sum of voltage signals received from the sensors differs by more than 15 %, the control logic will be informed of a ground fault.

Digital section

Functional description of the digital section

The digital section (Fig. 7) estimates the integrated heat load of the motor by digital integration into counters. The logic also participates in logic control during malfunctions of motor operations. The logic circuitry controls the signal level and frequency multiplexers of the analog section by generating the necessary control signal bit sequences. The relays controlling the alarm output and contactor's coil circuit receive their deenergization/energization control signals from the logic circuitry.

The analog section provides into the logic inputs a two-bit information on the selected current range, indication on overcurrent, phase leg fault, ground fault and error detection by the self-diagnostics. Further, a remote-control signal from the Reset line is also routed for the use of the control logic.

Configuration of the digital section

The digital control logic illustrated in Fig. 7 comprises the following blocks:
- Phase and level sequencer 71
  - Phase sequencer counter
    The phase sequencer counter counts to four (4). This two-bit information is routed to the phase multiplexer to wait for the handling of the desired phase leg current.
  - Voltage level counter
    By counting to ten (10), the voltage level counter generates the necessary sequence for voltage level multiplexer in order to select the voltage levels to the comparator. The sequence of the level counter allows for the detection of the current level.
  - Delay circuit of "Overcurrent" signal
    The delay circuit keeps the "Overcurrent" signal high until all three phase leg currents and the test phase have been compared and no overcurrent situation exists.
  - Level latch
    The level latch locks the level signal to the state prevailing at the reception of an overcurrent signal. This procedure guarantees the frequency multiplexer a stable control information of frequency.
- Frequency generator 72
  - Divide-by-2 divider
  - Divide-by-3 divider
  - Divide-by-4 divider
  - Divide-by-8 divider

13

- Divide-by-16 divider

  These dividers generate the necessary frequencies by chained division from the basic clock frequency (32 kHz).
- Frequency multiplexer 73

  The frequency multiplexer performs the selection of a proper frequency corresponding to the signal level for routing to the up/down counter. Additionally, the block allows the selection of tripping delay (i.e., frequency) of loaded motor starting with a rush current of $5 \cdot I_n$ in four (4) stages by external DIP switches. The frequency multiplexer takes the selected current range into account in the selection of frequencies corresponding to motor cooling in order to make the heat load estimation better compatible with the cooling rates of motors with different thermal masses.
- Up/down counter and level comparators 70
  - Up/down counter

    The up/down counter estimates the motor heat load by counting up in overcurrent situations and down in situations below the nominal current. The counting frequency is dependent on the current level, which is used by the frequency multiplexer in the selection of an appropriate frequency to the up/down counter.
  - Level comparator

    The level comparator delivers control signals to the up/down control input of the counter at detected current levels of 25 % and 70 %. A further control signal is issued at the reach of 90 % of the total allowable heat load. Additionally, the comparator provides information on the integrated heat load of the motor as estimated by the counter. The heat load signal is generated for the bus interface of the apparatus to be routed as a motor status signal to a process computer.
  - Stalled start detection logic 71

    The stalled start detection logic monitors the immediate violation of the $5 \cdot I_n$ overcurrent limit in start-up. If the violation takes place by the motor current exceeding the $5 \cdot I_n$ level immediately at start-up and staying at the high level up to tripping and if the tripping delay time is set for two seconds, the output buffer register will be automatically cleared after about 2 minutes. This clearing sequence is repeated only twice for a selected two-second restarting delay and once for the eight-second selection. Repeated start-up attempts must wait for the normal cool-off time of about 30 minutes.
  - Phase leg fault logic 76

    The phase leg fault logic receives information on a tripped fuse from the analog section. The control logic delays the tripping by about one (1) second.
  - Underload logic 71

    The underload logic detect the violation of a set lower load limit. The underload tripping function is optional.
  - Ground fault logic 76

    The ground fault logic can activate the alarm circuit. The alarm is initiated as soon as the ground fault is detected.
- Test sequencer 74

  The test sequence is initiated by pressing the "Test" pushbutton or application of the auxiliary supply voltage. The sequence is performed by applying a counting frequency corresponding to the two (2) second tripping delay to the counter. The counter performs counting normally until full, whereupon it performs switch-over of the relay status by issuing a trip signal as normal. Simultaneously with this operation the other counter is clocked with the lowest available frequency, which then activates a D flip-flop at the end of the low-frequency counting. If the first counter reaches it full contents within this time, the frequency generator and the up/down counter are functional.

Phase sequencer

Functional description of the phase sequencer

The phase sequencer (Fig. 10) forms the control signals (2 lines) for the commutation of phase leg currents measured in the analog section.

Configuration of the the phase sequencer

The phase sequencer is comprises a counter stepping through states 00, 01, 10, 11.

Voltage level sequencer

Functional description of the voltage level sequencer

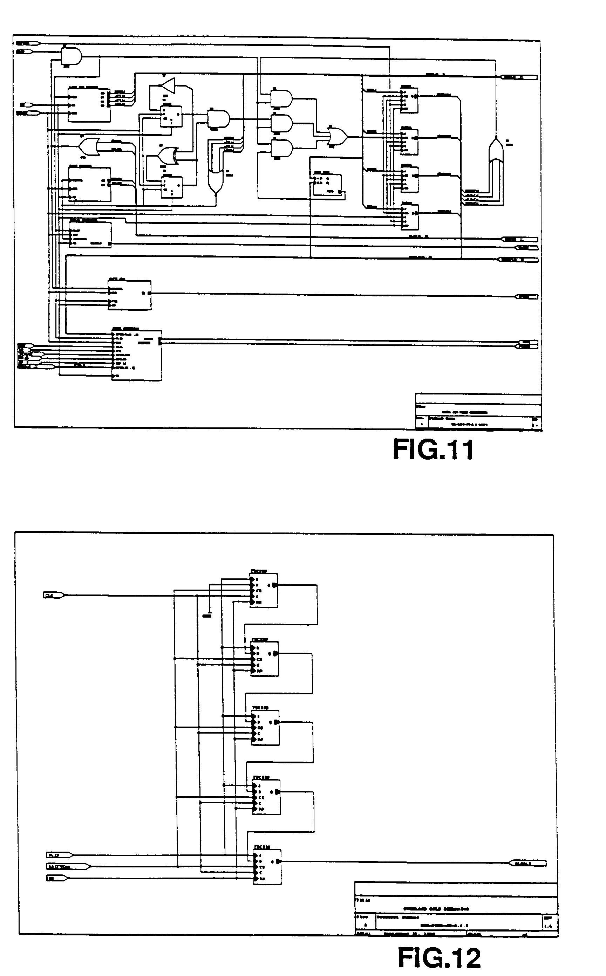

The voltage level sequencer (Fig. 11) generates the control signals for the analog section's multiplexer of compared voltage levels so that the highest level is applied first to the comparator. The four-bit (4) data of the voltage level sequencer and the comparator output allow the current level of a phase leg to be processed into digital form. The level information is taken into a latch circuit in order to obtain filtration of the level signal, which is taken to the multiplexer that selects the counting frequency for the counters.

Configuration of the voltage level sequencer

The voltage level sequencer comprises a four-bit (4) counter, which counts through the states 0000, 0001, 0010, 0011, 0100, 0101, 0110, 0111, 1000, 1001, 1010, 1011, 1100, 1101, 1110, 1111. These states correspond to the following voltage levels:

| | |
|------|------|
| 0000 | 0.0 |
| 0001 | 5.0 |
| 0010 | 4.0 |
| 0011 | 3.4 |
| 0100 | 2.8 |
| 0101 | 2.5 |
| 0110 | 2.0 |
| 0111 | 1.7 |
| 1000 | 1.45 |
| 1001 | 1.25 |
| 1010 | 1.19 |
| 1011 | 1.05 |
| 1100 | 0.95 |
| 1101 | 0.7 |
| 1110 | 0.5 |
| 1111 | 0.2 |

If the analog comparator detects a the signal level to exceed the set level of, for instance, $1.7 \cdot I_n$, the next sequence selected is again 0000 so that violation of a set level always restarts the comparison process of the levels.

Delay circuit of the "Overcurrent" signal

Functional description of the "Overcurrent" signal delay circuit

The delay circuit of the "Overcurrent" signal (Fig. 12) holds this alarm signal high until all phases and the test phase are sequenced through and no overcurrent situation exists during the sequencing. The delayed signal is necessary for the up/down counter to avoid hunting of the counting direction, which could lead to incorrect operation.

Configuration of the "Overcurrent" signal delay circuit

The delay circuit comprises a shift register, whose output is set to logic "one" as soon as the overcurrent situation is detected and the signal stays high until the three other phases have been scanned. If a new overcurrent signal is received, the shift register is cleared to its initial state, thereby necessitating a new sequence of three comparisons to be performed in a no overcurrent situation, before the delayed control is allowed to fall to logic "zero".

15

## Voltage level latch circuit

### Functional description of the voltage level latch circuit

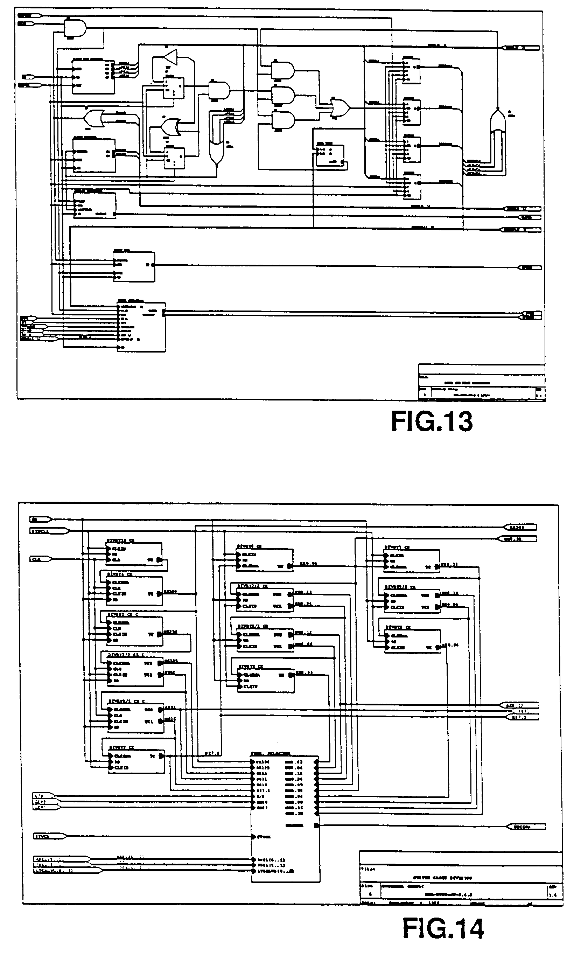

The voltage level latch circuit (Fig. 13) locks the voltage level signal in order to provide a stable signal to the frequency multiplexer. The frequency information is latched at rising edge of the "Overcurrent" signal. With the help of latching, the voltage level information is retained in the frequency multiplexer even during an active "Overcurrent" situation, thus making it possible for the counter to increment at a correct frequency.

### Configuration of the voltage level latch circuit

The voltage level latch circuit comprises four D flip-flops, which are activated by the "Overcurrent" signal and clocked by the system clock.

## Frequency generator

### Functional description of the frequency generator

The frequency generator (Fig. 14) generates the necessary frequencies to the counters from the 32 kHz basic clock frequency. Such a high system clock at 32 kHz achieves a stable operation of the divider chain.

### Configuration of the frequency generator

The divider chain is formed from divide-by-2, -3, -4, -8 and -16 dividers by appropriate chaining of the dividers.

## Frequency multiplexer

### Functional description of the frequency multiplexer

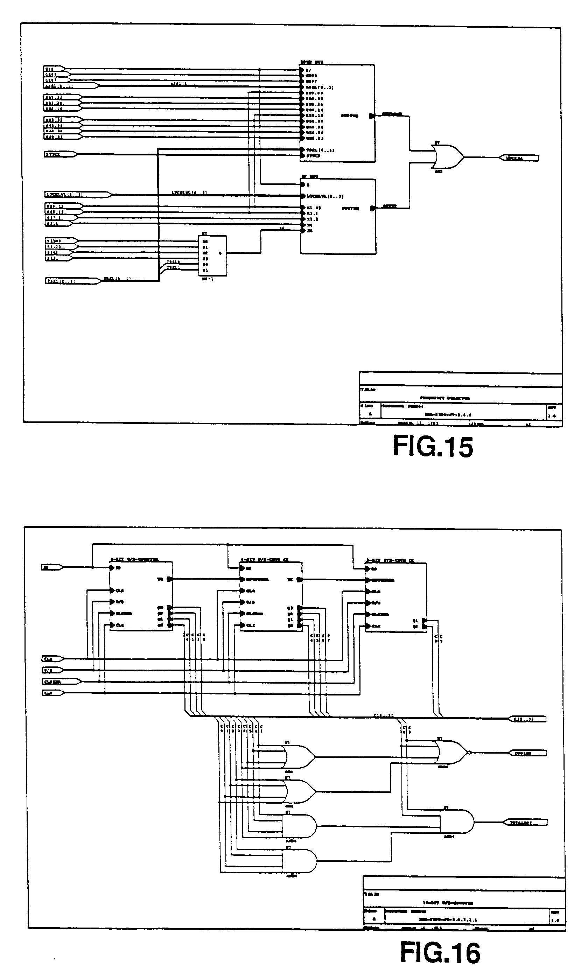

On the basis of the prevailing latched voltage level, the frequency multiplexer (Fig. 15) selects one of the frequencies generated by the frequency generator to be taken to up/down counter.

### Configuration of the frequency multiplexer

The multiplexer has a conventional configuration and its controls are received from the level latch circuit and the selection potentiometer of desired current range.

## Up/down counter and comparators

### Functional description of the up/down counter and comparator

The up/down counter (Fig. 16) estimates the motor temperature computationally. The counting frequency of the counter is dependent on the prevailing motor current level. The frequency selection is performed by the frequency multiplexer. When the counter reaches full count, it delivers the output buffer register a signal to cut off the counting frequency. When a current level in excess of $0.7 \cdot I_n$ has been detected, the counter is allowed to increment up to 25 % of the total allowable heat load (i.e. max. count of the counter) and is stopped there. If a current level of $0.95 \cdot I_n$ has been detected, the counter is allowed to count up to 75 % of the total allowable heat load before stopping. Finally, if the level $1.05 \cdot I_n$ is exceeded, the counter is inhibited from counting to maximum count until a period of two hours has elapsed. At the other overcurrent limits, the counting times are shortened according to the standardized time-current curve.

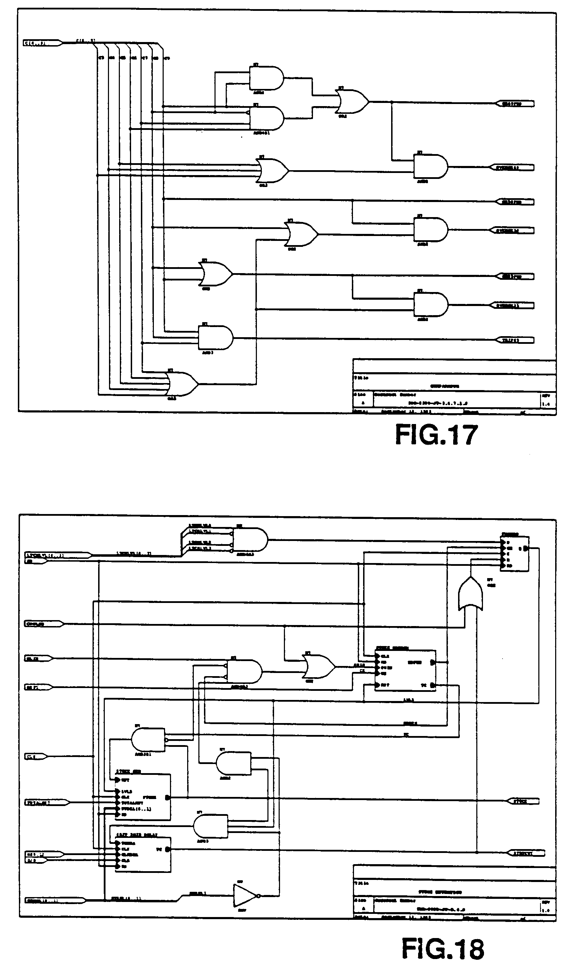

The comparators (Fig. 17) provide the indication of said 25 % and 70 % levels from the total allowable heat load. Additionally, the 90 % level is sensed to obtain a prewarning signal to be issued to the control center for an impending tripping.

Construction of the up/down counter and comparator

The up/down counter comprises a 10-bit up/down counter.

With the help of logic gates, the output bits of the up/down counter can be converted into levels representing the accumulated heat load. The 25 % and 70 % levels are generated for the up/down control signal of the counter and the 90 % level is generated for the impending tripping alarm.

Stalled start detector

Functional description of the stalled start detector

The stalled start detection logic (Fig. 18) monitors the immediate violation of the $5 \cdot I_n$ overcurrent limit in start-up. If the violation takes place by the motor current exceeding the $5 \cdot I_n$ level immediately at start-up and staying at the high level up to tripping, the output buffer register will be automatically cleared after 2 minutes. This automatic clearing sequence is repeated only twice for a selected two-second restarting delay and once for the eight-second selection. Repeated start-up attempts must wait for the normal cool-off time of about 30 minutes. If a level violation at a lower current level occurs between the attempts, the restarting sequence is reset necessitating its activation by the initiation sequence, viz., the counters are set to the heat load of nominal motor loading and the limit of first level violation is set to $5 \cdot I_n$.

Construction of the stalled start detector

The stalled start detection logic operates a conditional logic, whose activated state sets the elapse of a 2 min cooling period after which the clearing of the output buffer register is enabled. The initial condition is defined so that the counter must indicate a motor heat load below the total allowable value and the detection of overcurrent situation must occur at the $5 \cdot I_n$ level (sequence 001). If the level detection takes place at any other current level in the beginning of or during the start, the clearing function does not take place and is not activated until the initial condition is again attained. In order to allow for the settling of the true-RMS converter in the analog section, a period of approx. 200 ms is counted prior to the activation of the initial condition logic. The delay counter of the initial condition logic is cleared after one (1) second has elapsed from the detection of the first overcurrent transient unless a new transient is detected.

Phase fault monitoring logic

Functional description of the phase fault monitoring logic

The phase fault monitoring logic compares the phase leg currents with each other in the analog section, and if a difference greater than 90 % is detected, the relay is tripped if the fault signal stays active for one (1) second. The analog section provides the fault signal to the monitoring logic and the logic filters the signal by the one-second delay prior to issuing the relay the tripping signal. The delay avoids unnecessary tripping by a transient skew load situation.

Construction of the phase fault monitoring logic

The phase fault monitoring logic is implemented as a counter to make it possible to achieve the desired delay function.

Underload detection logic

Functional description of the underload detection logic

The underload detection logic is an user-selectable function. Additionally, the undercurrent levels are user-selectable. The undercurrent detection level can be set by four DIP-switches to one of the fixed values: 0.2, 0.5, 0.7 and $0.95 \cdot I_n$. If the running motor current falls below the set value, the logic issues an alarm signal to the control center and turns on the "Underload" LED lamp. The available undercurrent ranges are: <0.2, 0.2...0.5, 0.2...0.7 and $0.2...0.95 \cdot I_n$.

Configuration of the underload detection logic

The underload detection logic is configured to compare the latched current level information to the set undercurrent value and it issues an alarm signal if the motor current falls below the set value.

Ground fault detection logic

Functional description of the ground fault detection logic

The ground fault detection logic receives a signal from the analog section if the sum of the phase leg currents is their detected to differ by more than 15 % from a set value. The ground fault signal is directly routed to the output buffer register, which immediately issues the actual ground fault alarm signal. During start-up, however, this function is inhibited.

Construction of the ground fault detection logic

The ground fault detection logic is configured to issue an immediate alarm signal at the occurrence of a ground fault.

Test sequencer

Functional description of the test sequencer

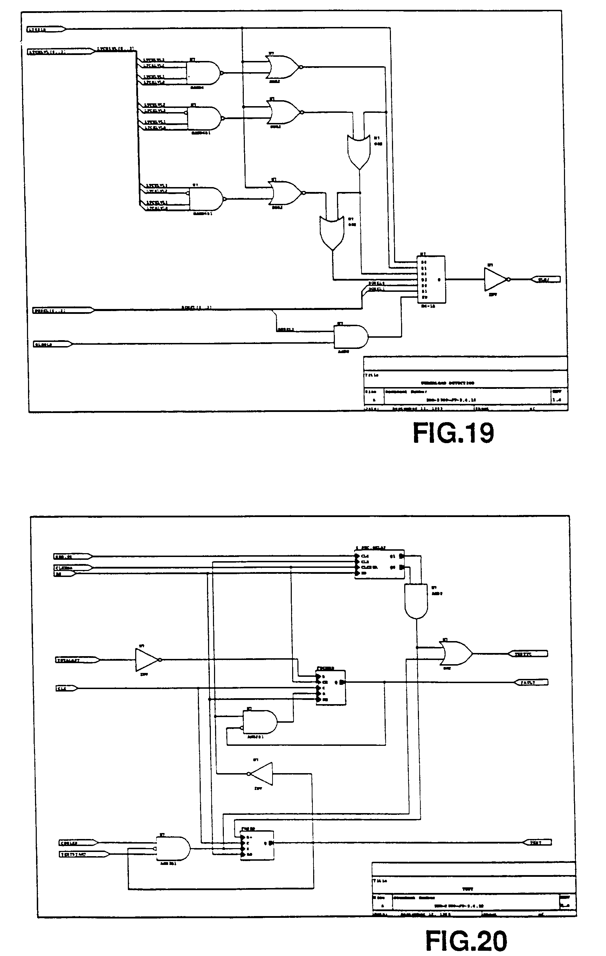

The test sequencer (Fig. 20) for the counters and output buffer register comprises a counter for the 2-second test duration. During this time, the entire test sequence must be performed as well as the entire circuitry be reset. Initiation of the test function by pressing the "Test" pushbutton is enable only when the motor status indicates a cool motor and the counter is in the decrementing mode. Pressing the "Test" pushbutton sets the counter to the incrementing mode, where it counts an appropriate frequency until tripping takes place in two seconds. After tripping, a reset pulse is issued to the entire circuitry thus initiating all functions.

Construction of the test sequencer

The test sequencer logic comprises discrete logic circuits and a D flip-flop with delayed enable.

Output buffer register

Functional description of the output buffer register

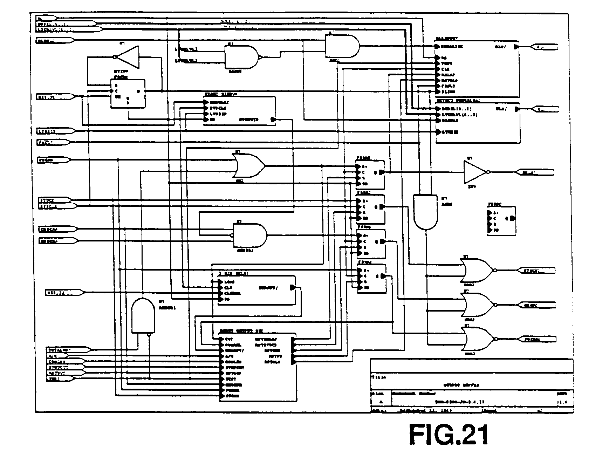

The output buffer register (Fig. 21) performs the latching of the control relay to a tripped state, whereby the appropriate LED lamp is lit to indicate the cause of tripping.

Construction of the output buffer register

Using latch circuits, the output buffer register stores the fault indication and trip signals received from the logic circuits and buffers them to the LED lamps and the control relay. The resetting of the LED lamps takes place always at a new tripping, thus allowing the last cause of tripping to be displayed on the control panel. The LED lamps can also be reset by the "Reset" pushbutton, for instance, when the user acknowledges the cause of tripping. The latch circuit driving the control relay is reset automatically when the selection switch "Auto/Man" is in the "Auto" position and the counter reach a state allowing a repeated attempt of start-up. If the switch is set to position "Man", the tripped relay must be reset by the "Reset" pushbutton, whose function is, however, inhibited for two minutes from the previous tripping.

Control element

Functional description of the control element

The control element of the apparatus is a relay which interfaces the low-level control signals from the low-level logic to an appropriate level for the controlled contactors and the alarm circuit.

Construction of the control element

The control logic of the overload relay is configured so that in normal operation the contacts controlling the contactor's coil circuit are held closed (N/C contacts) in order to avoid unnecessary deenergization of the coil circuit at a loss of the auxiliary supply voltage, thus precluding functional errors. Correspondingly, the alarm circuit is connected to the logically inverted position of the relay (N/C contacts) to obtain an immediate alarm at a loss of the auxiliary supply voltage.

The relays used are conventional miniature-size relays with pin configurations applicable for PCB mounting.

Alternative constructions

The current measurements can also be implemented using current transformers, but their measurement range is much more limited which will require a larger number of different relay modules. The construction of the logic circuitry itself is possible to implement in analog form using resistor and capacitor networks, multiplexers and comparators but this construction has stability problems.

**Claims**

1. An apparatus for measuring current in current carrying conductors (82;90) in conditions of high interference, in particular to control an overcurrent trip relay, said apparatus comprising:
   - Hall-effect sensors (81; 92, 93) each Hall-effect sensor (81; 92, 93) placed in close proximity to its respective current conductor (82; 90),
   - each Hall-effect sensor (81; 92, 93) connected to a voltage measuring element, whose output provides a measurement signal which is suitable for computation of the current level in the respective conductor (82; 90), said apparatus
   characterized by
   - a comb-shaped core (84b) fabricated of a ferromagnetic material capable of concentrating the magnetic field induced by the current of the respective conductor (82; 90) and operating as an interference filter,
   - said comb-shaped core (84b) comprising a body and a plurality of teeth,
   - each Hall-effect sensor (81; 92, 93) and its respective conductor (82; 90) being placed between adjacent teeth of the comb-shaped core (84b) and
   - each conductor (82; 90) lying between the respective Hall-effect sensor (81; 92, 93) and the body of said comb-shaped core (84b).

2. An apparatus in accordance with claim 1, **characterized** in that the measurement section of said apparatus is enclosed in a Faraday shield.

3. An apparatus in accordance with claim 1 or 2, **characterized** in that the apparatus is provided with a reference sensor (83) having an identical construction with that of the measurement Hall-effect sensors (81; 92, 93) but being displaced from the immediate vicinity of a current conductor (82; 90).

4. An apparatus in accordance with any of the preceding claims, **characterized** in that the apparatus is further provided with counter elements, which allow the integration of the measurement signal corresponding to the current level, thus making it possible to estimate the temperature of a motor acting as the load connected to the current conductors (82).

5. A method for measuring electric current in current carrying conductors (82;90) in conditions of high interference, in particular to control an overcurrent trip relay, in which method

- the magnetic flux density induced by each current conductor (82; 90) is measured by its respective Hall-effect sensor (81; 92, 93),
- the voltage output signal of each Hall sensor (81; 92, 93) being proportional to the magnetic flux density is used for computation of the current level in the respective current conductor (82; 90), characterized in that
- the magnetic flux imposed on each Hall sensor by the respective current conductor (82; 90) is increased by means of a comb-shaped core (84b) fabricated from a ferromagnetic material and placed so that each current conductor (82; 90) remains within the closed magnetic circuit formed by the core (84b) of ferromagnetic material and the respective Hall sensor (81; 92, 93),
- said comb-shaped core (84b) comprising a body and a plurality of teeth,
- each Hall-effect sensor (81; 92, 93) and its respective conductor (82; 90) being placed between adjacent teeth of the comb-shaped core (84b) and
- each conductor (82; 90) lying between the respective Hall-effect sensor (81; 92, 93) and the body of said comb-shaped core (84b).

6. A method in accordance with claim 5, **characterized** in that a reference sensor (83) identical to the measurement Hall-effect sensors is used and the measurement result of the reference sensor (83) is subtracted from the measurement result of each measurement sensor (81; 92, 93) in order to eliminate the effect of interference.

7. A method in accordance with claim 5 or 6, **characterized** in that the measured signal is integrated in order to estimate the heat quantity being entered into a motor acting as the load connected to the current conductors (82).

**Patentansprüche**

1. Vorrichtung zur Strommessung in stromführenden Leitern (82;90) unter Bedingungen hoher Interferenz, insbesondere zur Steuerung eines Überstrom-Auslöserelais, mit:
   - Hall-Effekt-Sensoren (81;92,93), wobei jeder Hall-Effekt Sensor (81;92,93) in unmittelbarer Nähe seines zugehörigen Stromleiters (82;90) angeordnet ist,
   - wobei jeder Hall-Effekt-Sensor (81;92,93) mit einem Spannungsmeßelement verbunden ist, dessen Ausgangssignal ein Meßsignal bereitstellt, welches geeignet ist zur Berechnung des Stromflusses in dem zugehörigen Leiter (82;90),
   **gekennzeichnet** durch
   - ein kammförmiges Herz (84b) aus ferromagnetischem Material, das in der Lage ist, das durch den Stromfluß des zugehörigen Leiters (82;90) induzierte magnetische Feld zu bündeln und als Interferenzfilter zu arbeiten,
   - wobei das kammförmige Herz (84b) einen Körper und mehrere Zähne aufweist,
   - wobei jeder Hall-Effekt-Sensor (81;92,93) und dessen zugehöriger Leiter (82;90) zwischen benachbarten Zähnen des kammförmigen Herzens (84b) angeordnet ist, und
   - jeder Leiter (82;90) zwischen dem zugehörigen Hall-Effekt-Sensor (81;92,93) und dem Körper des kammförmigen Herzens (84b) liegt.

2. Vorrichtung nach Anspruch 1,
   dadurch **gekennzeichnet**,
   daß der Meßteil der Vorrichtung in einem Faraday-Käfig eingeschlossen ist.

3. Vorrichtung nach Anspruch 1 oder 2,
   dadurch **gekennzeichnet**,
   daß die Vorrichtung einen Referenzsensor (83) aufweist, der identisch zu den zu messenden Hall-Effekt-Sensoren (81;92,93) aufgebaut ist, jedoch entfernt von der unmittelbaren Umgebung eines Stromleiters (82;90) angeordnet ist.

4. Vorrichtung nach einem der Vorhergehenden Ansprüche,
   dadurch **gekennzeichnet**,
   daß die Vorrichtung weiterhin Zählelemente aufweist, die die Integration des dem Stromfluß entsprechenden Meßsignals erlauben und es so möglich machen, die Temperatur eines Motors abzuschätzen, der als mit den Stromleitern (82) verbundene Last fungiert.

EP 0 464 076 B1

5. Verfahren zur elektrischen Strommessung in stromführenden Leitern (82;90) unter Bedingungen hoher Interferenz, insbesondere zur Steuerung eines Überstrom-Auslöserelais, mit folgenden Verfahrensschritten:

- Die durch jeden Stromleiter (82;90) induzierte magnetische Flußdichte wird durch seinen zugehörigen Hall-Effekt-Sensor (81;92,93) gemessen,
- das Spannungsausgangssignal jedes Hall-Effekt-Sensors (81;92,93), das proportional zur magnetischen Flußdichte ist, wird verwendet zur Berechnung des Stromflusses in dem zugehörigen Stromleiter (82;90),
dadurch **gekennzeichnet**, daß
- der durch den zugehörigen Stromleiter (82;90) auf jeden Hall-Sensor einwirkende magnetische Fluß mittels eines kammförmigen Herzens (84b) aus ferromagnetischem Material erhöht wird, das derart angeordnet wird, daß jeder Stromleiter (82;90) in dem geschlossenen magnetischen Kreis bleibt, der durch das Herz (84b) aus ferromagnetischem Material und dem zugehörigen Hall-Sensor (81;92,93) gebildet wird,
- wobei das kammförmige Herz (84b) einen Körper und mehrere Zähne aufweist,
- wobei jeder Hall-Effekt-Sensor (81;92,93) und sein zugehöriger Leiter (82;90) zwischen benachbarten Zähnen des kammförmigen Herzens (84b) angeordnet wird und
- jeder Leiter (82;90) zwischen dem zugehörigen Hall-Effekt-Sensor (81;92,93) und dem Körper des kammförmigen Herzens (84b) liegt.

6. Verfahren nach Anspruch 5,
dadurch **gekennzeichnet**,
daß ein Referenzsensor (83) Verwendet wird, der identisch zu den messenden Hall-Sensoren ausgebildet ist, und
daß das Meßergebnis des Referenzsensors (83) von dem Meßergebnis jedes messenden Sensor (81;92,93) abgezogen wird, um den Interferenz-Effekt zu eliminieren.

7. Verfahren nach Anspruch 5 oder 6,
dadurch **gekennzeichnet**,
daß das gemessene Signal integriert wird, um die Hitze abzuschätzen, die in einem Motor erzeugt wird, der als mit den Stromleitern (82) verbundene Last fungiert.

**Revendications**

1. Dispositif pour mesurer le courant dans des conducteurs de courant (82;90) dans des conditions d'interférences intenses, en particulier pour la commande d'un relais de déclenchement à surintensité, ledit dispositif comprenant :
- des capteurs à effet Hall (81;92,93), dont chacun est placé à proximité directe de son détecteur respectif de courant (82;90),
- chaque capteur à effet Hall (81;92,93) étant connecté un élément de mesure de tension, dont la sortie délivre un signal de mesure qui convient pour le calcul de l'intensité du courant dans le conducteur respectif (82; 90),
ledit dispositif étant caractérisé par
- un noyau en forme de peigne (84b) réalisé en un matériau ferromagnétique apte à concentrer le champ magnétique induit par le courant du conducteur respectif (82;90) et fonctionnant en tant que filtre d'interférences,
- ledit noyau en forme de peigne (84b) comprenant un corps et une pluralité de dents,
- chaque capteur à effet Hall (81;92,93) et son conducteur respectif (82;90) étant disposé entre des dents adjacentes du noyau en forme de peigne (84b), et
- chaque conducteur (82;90) étant situé entre le capteur à effet Hall (81;92,93) et le corps dudit noyau en forme de peigne (84b).

2. Dispositif selon la revendication 1, caractérisé en ce que la section de mesure dudit dispositif est renfermée dans un blindage de Faraday.

3. Dispositif selon la revendication 1 ou 2, caractérisé en ce que le dispositif est équipé d'un capteur de référence (83) possédant une structure identique à celle des capteurs de mesure à effet Hall (81;92,93), mais écartée du voisinage immédiat d'un conducteur de courant (82; 90).

21

4. Dispositif selon l'une quelconque des revendications précédentes, caractérisé en ce qu'il est en outre équipé d'éléments de comptage, qui permettent l'intégration du signal de mesure correspondant à l'intensité du courant, ce qui permet d'estimer la température d'un moteur agissant en tant que charge raccordée aux conducteurs de courant (82).

5. Procédé pour mesurer un courant électrique dans des conducteurs de courant (82;90) dans des conditions d'interférences intenses, en particulier pour la commande d'un relais de déclenchement à surintensité, procédé selon lequel
   - la densité de flux magnétique induite par chaque conducteur de courant (82;90) est mesurée par son capteur à effet Hall respectif (81;92,93),
   - le signal de sortie de tension de chaque capteur à effet Hall (81;92,93), qui est proportionnel à la densité de flux magnétique, est utilisé pour le calcul de l'intensité du courant dans le conducteur de courant respectif (82;90),
        caractérisé en ce que
   - le flux magnétique appliqué à chaque capteur de Hall par le conducteur de courant respectif (82;90) est accru au moyen d'un noyau en forme de peigne (84b) réalisé en un matériau ferromagnétique et le capteur de Hall respectif (81;92,93),
   - ledit noyau en forme de peigne (84b) comportant un corps et une pluralité de dents,
   - chaque capteur à effet Hall (81;92,93) et son conducteur respectif (82;90) étant disposés entre les dents adjacentes du noyau en forme de peigne (84b), et
   - chaque conducteur (82;90) étant situé entre le capteur à effet Hall respectif (81;92,93) et le corps dudit noyau en forme de peigne (84b).

6. Procédé selon la revendication 5, caractérisé en ce qu'on utilise un capteur de référence (83) identique aux capteurs de mesure à effet Hall et que le résultat de la mesure du capteur de référence (83) est soustrait du résultat de mesure de chaque capteur de mesure (81;92,93), de manière à supprimer l'effet d'interférence.

7. Procédé selon la revendication 5 ou 6, caractérisé en ce que le signal mesuré est intégré afin d'estimer la quantité de chaleur introduite dans un moteur agissant en tant que charge raccordée aux conducteurs de courant (82).

**FIG.1**

**FIG.2**

**FIG.3**

**FIG.4**

**FIG.5**

**FIG.6**

FIG.7

FIG.8

FIG.9

FIG.10

27

**FIG.11**

**FIG.12**

FIG.13

FIG.14

FIG.15

FIG.16

EP 0 464 076 B1

FIG.17

FIG.18

31

EP 0 464 076 B1

FIG.19

FIG.20

32

EP 0 464 076 B1

FIG.21